# EUROPEAN PATENT SPECIFICATION

(11) **EP 1 635 458 B1**
(45) Date of publication and mention of the grant of the patent: **14.12.2011**
(21) Application number: 04725791.0
(22) Date of filing: 05.04.2004
(51) Int. Cl.: H03H 9/145, H03H 9/25, H03H 9/02

(54) **Surface acoustic wave device**
Oberflächenwellenbauelement
Dispositif à ondes acoustiques de surface

(30) Priority: 17.06.2003 JP 2003171671
(43) Date of publication of application: 15.03.2006
(73) Proprietor: MURATA MANUFACTURING CO., LTD., Nagaokakyo-shi, Kyoto 617-8555 (JP)
(72) Inventor: HADA, Takuo c/o Murata Manufacturing Co., Ltd., Nagaokakyo-shi, Kyoto 617-8555 (JP); NAKAO, Takeshi c/o Murata Manufacturing Co., Ltd., Nagaokakyo-shi, Kyoto 617-8555 (JP); KADOTA, Michio c/o Murata Manufacturing Co., Ltd., Nagaokakyo-shi, Kyoto 617-8555 (JP); NAKAGAWARA, Osamu c/o Murata Manufacturing Co.Ltd., Nagaokakyo-shi, Kyoto 617-8555 (JP)
(74) Representative: Thévenet, Jean-Bruno
(86) International application number: PCT/JP2004/004896
(87) International publication number: WO 2004/114521

(56) References cited:
- EP-A- 0 991 186
- WO-A1-03/005577
- GB-A- 2 381 976
- JP-A- 5 022 067
- JP-A- 7 122 961
- JP-A- 8 204 493
- JP-A- 8 227 656
- JP-A- 9 069 748
- JP-A- 9 098 043
- JP-A- 9 199 976
- JP-A- 54 132 187
- JP-A- 2002 026 685
- JP-A- 2002 026 685
- JP-A- 2002 043 888
- JP-A- 2003 152 498
- JP-A- 2003 152 498
- JP-A- 2003 243 961
- JP-U- 52 001 040
- US-A1- 2002 113 526
- SCHMIDT H ET AL: "Investigation of SAW-induced acoustomigration effects in Cu- and Al-based metallizations" 2001 IEEE ULTRASONICS SYMPOSIUM, vol. 2, 7 October 2001 (2001-10-07), - 10 October 2001 (2001-10-10) pages 97-100, XP010584487
- NISHIHARA T ET AL: "Improvement in power durability of SAW filters" IEEE ULTRASONICS SYMPOSIUM, vol. 1, 7 November 1995 (1995-11-07), - 10 November 1995 (1995-11-10) pages 383-388, XP010157230
- JIN YONG KIM ET AL: "Passivation layer effects on power durability of SAW duplexer" IEEE ULTRASONICS SYMPOSIUM, vol. 1, 17 October 1999 (1999-10-17), - 20 October 1999 (1999-10-20) pages 39-42, XP010502272
- DATABASE INSPEC [Online] THE INSTITUTION OF ELECTRICAL ENGINEERS, STEVENAGE, GB; 2002, NAKAGAWARA O ET AL: "High power durable SAW antenna duplexers for W-CDMA with epitaxially grown aluminum electrodes", Database accession no. 7735501 & PROCEEDINGS OF 2002 IEEE INTERNATIONAL ULTRASONICS SYMPOSIUM 8-11 OCT. 2002 MUNICH, GERMANY, vol. 1 , pages 43-46 vol.1, 2002 IEEE Ultrasonics Symposium. Proceedings (Cat. No.02CH37388) IEEE Piscataway, NJ, USA DOI: DOI:10.1109/ULTSYM.2002.1193349 ISBN: 0-7803-7582-3

## Description

### Technical Field

The present invention relates to surface acoustic wave devices for use in, for example, resonators and filters, and more specifically to a surface acoustic wave device including interdigital electrodes mainly containing Cu.

### Background Art

Surface acoustic wave devices are electronic components that exploit a surface acoustic wave, which is a mechanical vibrational energy propagating only in the vicinity of a solid surface. In general, surface acoustic wave devices include a piezoelectric substrate and interdigital electrodes formed thereon and are used as filters and resonators.

Surface acoustic wave devices generally include electrodes formed of Al or an Al-based alloy mainly containing Al, which has low resistance and low specific gravity. Electrodes formed of Al or an Al-based alloy, however, readily cause short circuits due to stress migration, exhibit high insertion loss, and have insufficient power resistance.

Japanese Unexamined Patent Application Publication Nos. 9-98043, 9-199976, and 2002-26685 have proposed the use of Cu electrodes for surface acoustic wave devices. Specifically, Japanese Unexamined Patent Application Publication No. 9-98043 discloses a surface acoustic wave device including comb-shaped electrodes formed of Cu or a Cu alloy mainly containing Cu.

A surface acoustic wave device according to Japanese Unexamined Patent Application Publication No. 9-199976 includes electrodes formed of an alloy having a composition represented by CuxMy, wherein x and y are expressed as weight percentages and M is a metal selected from, for example, Zn, Ni, Sn, Al, and Mg. According to the publication, electrodes formed of a Cu alloy containing, for example, Zn, Ni, Sn, Al, or Mg can achieve higher oxidation resistance.

Japanese Unexamined Patent Application Publication No. 9-199976 also discloses that the oxidation resistance of such electrodes can be further increased by forming an inorganic protective layer, such as SiON, Si02, or Al203, on the electrodes.

Japanese Unexamined Patent Application Publication No. 2002-26685 discloses a surface acoustic wave element including a piezoelectric substrate, a first electrode layer formed on the substrate, a second electrode layer formed on the first electrode layer, and a third electrode layer formed over the second electrode layer. The first electrode layer is formed of Ti or a Ti alloy and has a thickness of 10 nm. The second electrode layer is formed of Cu or a Cu alloy. The third electrode layer is formed of Al, Au, or an alloy mainly containing Al or Au. According to the publication, the first electrode layer, which is formed of Ti or a Ti alloy, can increase the adhesion between the piezoelectric substrate and the electrodes, and the third electrode layer provides higher oxidation resistance.

Unfortunately, electrodes formed of Cu have insufficient adhesion to piezoelectric substrates and exhibit insufficient oxidation resistance because Cu is readily oxidized.

According to Japanese Unexamined Patent Application Publication No. 9-199976, the oxidation resistance of the electrodes is increased by forming a protective layer with an inorganic insulating material, such as SiON or Si02, on the electrodes and using a Cu alloy containing, for example, Zn, Ni, or Sn.

Recently, on the other hand, filters and multiplexers for use on the transmitter side of communication equipment require still higher power resistance as the communication equipment uses higher frequencies. Accordingly, higher adhesion between electrodes and piezoelectric substrates has been strongly demanded.

The surface acoustic wave devices according to Japanese Unexamined Patent Application Publication Nos. 9-98043 and 9-199976 have difficulty in achieving sufficient adhesion of electrodes to a piezoelectric substrate for higher power resistance.

The surface acoustic wave element according to Japanese Unexamined Patent Application Publication No. 2002-26685 includes the first electrode layer, which is formed of Ti or a Ti alloy and has a thickness of 10 nm, to increase the adhesion between the electrodes and the piezoelectric substrate. This structure, however, still cannot provide sufficient power resistance.

JP 2003-152498 describes a SAW element having good power resistivity. This SAW element uses a laminated electrode structure formed on the surface of a single crystal LiNbO₃ or LiTaO₃ substrate after a deformed layer has been removed therefrom. The electrode structure has a base electrode layer containing at least one of Ti, Cr and Ni as a main component and having a thickness of 1-100 nm, and a main layer formed primarily of Al (doped with 10 wt % of Cu, Ti, Mg, Ni, Mo or Sc). The base layer is thin enough that the Al crystal forming the main electrode layer has an epitaxial relationship with the crystalline structure of the substrate.

JP 2002-026685 describes a SAW element using electrodes having a laminated structure including a Cu layer. The lowermost layer of these electrodes is formed of Ti or a Ti alloy, the second layer is made of Cu or a Cu alloy and the uppermost layer is made of Al (or Au) or an alloy whose main component is Al (or Au).

GB-A-2 381 976 describes a SAW device in which the electrode pads that are used for connecting the IDT electrodes to external terminals of a package have a laminated structure. An adhesive layer of Ti, Ni or an Ni-Cr alloy is provided between the lowermost layer of the electrode pad and the adjacent layer thereof.

### Disclosure of Invention

In light of the above circumstances in the related art, an object of the present invention is to provide a surface acoustic wave device that has electrodes including a main electrode layer formed of Cu and can achieve higher adhesion of the electrodes to a piezoelectric substrate and higher power resistance.

A surface acoustic wave device according to a general aspect of the invention of the present application includes a piezoelectric substrate and interdigital electrodes formed thereon. The interdigital electrodes each include: a main electrode layer formed of Cu or an alloy mainly containing Cu, and an adhesive layer disposed between the main electrode layer and the substrate and mainly containing NiCr, wherein the thickness of the adhesive layer which is normalized with respect to the wavelength of a surface acoustic wave is 0.0025 to 0.025.

According to a specific aspect of the first invention, the adhesive layer has a thickness of 5 to 50 nm.

According to a specific aspect of the invention, the surface acoustic wave device further includes a protective layer disposed on the main electrode layer and mainly containing a metal having higher oxidation resistance than Cu.

According to a more specific aspect of the invention, the protective layer is formed of an Al-Cu alloy. In addition, preferably, an electrode layer formed of Ti or NiCr is disposed between the protective layer and the main electrode layer.

According to another specific aspect of the invention, the surface acoustic wave device further includes a Si02 film formed over the interdigital electrodes.

### Brief Description of the Drawings

Fig. 1 is a schematic sectional elevation illustrating the electrode structure of a surface acoustic wave device according to an embodiment of the present invention.
Fig. 2 is a graph showing the breakdown power of a surface acoustic wave device prepared in Example 1 which includes no protective layer and those of surface acoustic wave devices prepared in Example 1 which include protective layers formed of different materials.
Fig. 3 is a graph showing the minimum insertion loss points in the attenuation-frequency characteristics of the surface acoustic wave device prepared in Example 1 which includes no protective layer and the surface acoustic wave devices prepared in Example 1 which include protective layers formed of different materials.
Fig. 4 is a graph showing changes in breakdown power with varying thicknesses of adhesive layers in Example 2.
Fig. 5 is a graph showing changes in minimum insertion loss point in attenuation-frequency characteristics with varying thicknesses of the adhesive layers in Example 2.
Fig. 6 is a plan view showing the electrode structure of a one-port surface acoustic wave resonator as an example of a surface acoustic wave device according to the present invention.
Fig. 7 is a plan view showing the electrode structure of a two-port surface acoustic wave resonator as another example of a surface acoustic wave device according to the present invention.
Fig. 8 is a schematic plan view showing the electrode structure of a ladder surface acoustic wave filter as another example of a surface acoustic wave device according to the present invention.
Fig. 9 is a schematic plan view showing the electrode structure of a lattice surface acoustic wave filter as another example of a surface acoustic wave device according to the present invention.

### Best Mode for Carrying Out the Invention

Specific embodiments of the present invention will now be described with reference to the drawings to clarify the present invention.

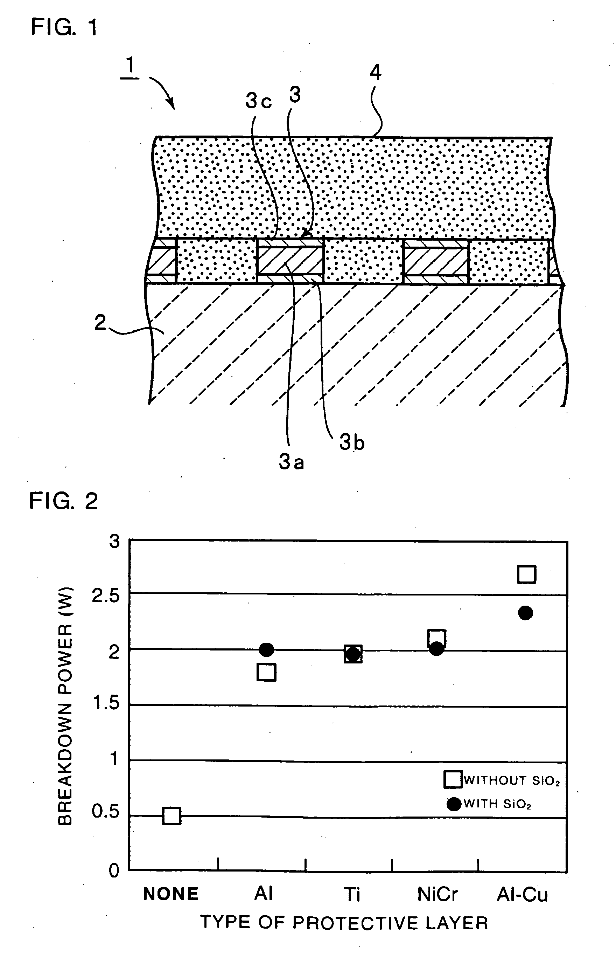

Fig. 1 is a schematic sectional elevation illustrating the electrode structure of a surface acoustic wave device according to an embodiment of the present invention. A surface acoustic wave device 1 includes a piezoelectric substrate 2. The piezoelectric substrate 2 used in this embodiment is a 36° rotated Y-cut X-propagation LiTaO3 substrate, though LiTaO3 substrates with other rotation angles may also be used in the present invention. Alternatively, the piezoelectric substrate 2 may be formed of another piezoelectric single-crystal material, such as LiNb03 or quartz.

Interdigital electrodes 3 are formed on the piezoelectric substrate 2. These interdigital electrodes 3 have a plurality of electrode fingers. The surface acoustic wave device 1 in this embodiment is characterized in that the interdigital electrodes 3 each include a main electrode layer 3a, an adhesive layer 3b disposed between the main electrode layer 3a and the piezoelectric substrate 2, and a protective layer 3c provided on the top surface of the main electrode layer 3a. The protective layer 3c does not necessarily have to be provided in the present invention.

The main electrode layer 3a is formed of Cu or an alloy mainly containing Cu; Cu is used in this embodiment. Because electrodes formed of Cu or an alloy mainly containing Cu, as described above, disadvantageously have insufficient adhesion to a piezoelectric substrate, the surface acoustic wave device 1 includes the adhesive layer 3b to improve the adhesion.

In this embodiment, the adhesive layer 3b is formed of a NiCr alloy to improve the adhesion of the interdigital electrodes 3 to the piezoelectric substrate 2 effectively, as will be demonstrated in examples below.

The protective layer 3c is formed of a material mainly containing a metal having higher oxidation resistance than Cu. Examples of such a metal include Al, Ti, Cr, Ni, Pt, Pd, and alloys such as NiCr and AlCu.

The protective layer 3c is preferably formed of an AlCu alloy to provide higher power resistance with no significant effect on the frequency characteristics of the surface acoustic wave device 1. If the protective layer used is formed of Al alone, which has excellent corrosion resistance, Al and the Cu contained in the main electrode layer diffuse into each other in a power resistance test, thus posing difficulty in providing sufficient power resistance. This is because the interdiffusion between Cu and Al requires low activation energy.

In contrast, a protective layer formed of an Al-Cu alloy can provide both the resistance to organic solvents and excellent power resistance. In a power resistance test, intermigration in the Al-Cu alloy consumes heat energy and vibrational energy to inhibit the interlayer diffusion between the main electrode layer and the protective layer. Accordingly, as described above, a protective layer formed of an Al-Cu alloy can provide higher power resistance with no significant effect on frequency characteristics.

In addition, another electrode layer formed of Ti or NiCr is preferably provided between the protective layer, which is formed of an Al-Cu alloy, and the main electrode layer, which is formed of Cu, to inhibit the interdiffusion therebetween more effectively. The additional electrode layer can inhibit the interdiffusion between Al-Cu and Cu more effectively to provide still higher oxidation resistance.

The surface acoustic wave device 1 further includes a SiO2 layer 4 formed over the interdigital electrodes 3 to improve the frequency characteristics of the surface acoustic wave device 1 with respect to temperature. The surface of the SiO2 layer 4 is preferably planarized. The Si02 layer 4 does not necessarily have to be provided in surface acoustic wave devices according to the present invention.

Next, specific examples of surface acoustic wave devices according to the present invention are described below to demonstrate that the adhesion of interdigital electrodes to a piezoelectric substrate and the power resistance of the electrodes can be increased effectively.

### Example 1

A NiCr adhesive layer having a thickness of 20 nm was formed on 36° rotated Y-cut X-propagation LiTaO3 substrates as the adhesive layer 3b. A Cu electrode film was then formed as the main electrode layer 3a. The electrode film had a normalized thickness λW = 0.030, wherein h is the thickness (nm) of the main electrode layer, namely 60 nm; and λW is the wavelength (nm) of a surface acoustic wave, which is determined by the pitch of the interdigital electrodes 3. The protective layer 3c was then formed with different metals at a thickness of 10 nm. The electrode pitch was 1 nm, and the width of the electrode fingers was 0.5 nm.

Thus, a surface acoustic wave device including no protective layer 3c and surface acoustic wave devices including the protective layers 3c formed of different metals were prepared. In addition, surface acoustic wave devices including a SiO2 film formed over the interdigital electrodes were prepared. The SiO2 film had a normalized thickness hs/λW = 0.10, wherein hs is the thickness (nm) of the SiO2 film.

The surface acoustic wave devices thus prepared were subjected to a power resistance test in which the attenuation-frequency characteristics of the devices were measured while power was applied to the devices. Specifically, the power applied was started from 0.1 W and was increased stepwise (each step was continued for five minutes). The power applied when it was recognized that the minimum insertion loss point of the attenuation-frequency characteristics deteriorated by 0.5 dB or more was determined as the breakdown power.

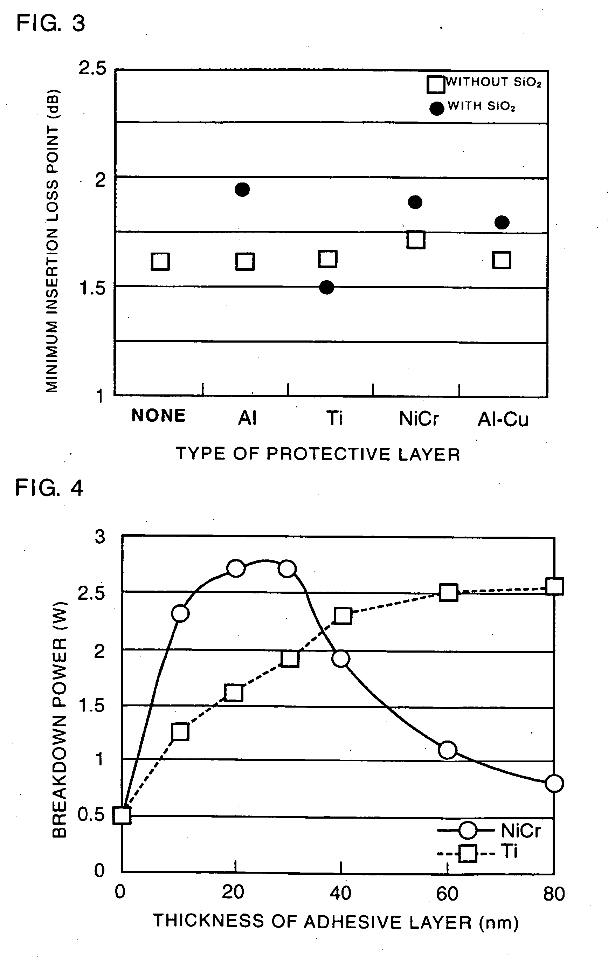

Fig. 2 is a graph showing the relationship between the types of protective layers of the surface acoustic wave devices and the resultant breakdown powers. Fig. 3 is a graph showing the relationship between the types of protective layers and the minimum insertion loss points.

Fig. 2 clearly shows that the surface acoustic wave devices including the protective layer 3c, which functions to inhibit the oxidation of Cu, exhibited significantly higher breakdown powers than the device including no protective layer. These results show that the protective layer 3c can increase the power resistance effectively. Fig. 2 shows the results of the case where no protective layer was provided and the cases where the materials used for the protective layer 3c were Al, Ti, NiCr, and AlCu. It was also found that the breakdown power could be similarly increased for protective layers formed of other metals having higher oxidation resistance than Cu, such as Cr, Ni, Pt, and Pd.

That is, the results in Fig. 2 show that both the oxidation resistance and the power resistance can be increased effectively by forming the protective layer 3c with a metal having higher oxidation resistance than Cu.

On the other hand, Fig. 3 clearly shows that the surface acoustic wave devices including the protective layer 3c had minimum insertion loss points similar to that of the device including no protective layer 3c. These results show that the protective layer 3c can increase the power resistance effectively with no significant effect on the frequency characteristics of the surface acoustic wave device 1.

In addition, Fig. 2 clearly shows that little difference in power resistance resulted between the cases where the SiO2 film was formed and the cases where no SiO2 film was formed. Fig. 3 clearly shows that no significant difference in minimum insertion loss point resulted between the cases where the Si02 film was formed and the cases where no Si02 film was formed. These results suggest that the Si02 film 4 is preferably formed to provide a surface acoustic wave device having excellent power resistance, adhesion, and frequency characteristics with respect to temperature.

If the SiO2 film is formed, the protective layer 3c is preferably formed of a material with good adhesion to SiO2 (for example, Ti).

### Example 2

The same power resistance test as in Example 1 was carried out with varying thicknesses of the adhesive layer 3b. Surface acoustic wave devices were prepared in the same manner as in Example 1 except that NiCr and Ti were used as the materials for the adhesive layer 3b and its thickness was varied. A Cu film having a normalized thickness h/λW = 0.030, namely a thickness of 60 nm, was formed as the main electrode layer 3a, and an Al film having a thickness of 10 nm was formed as the protective layer 3c.

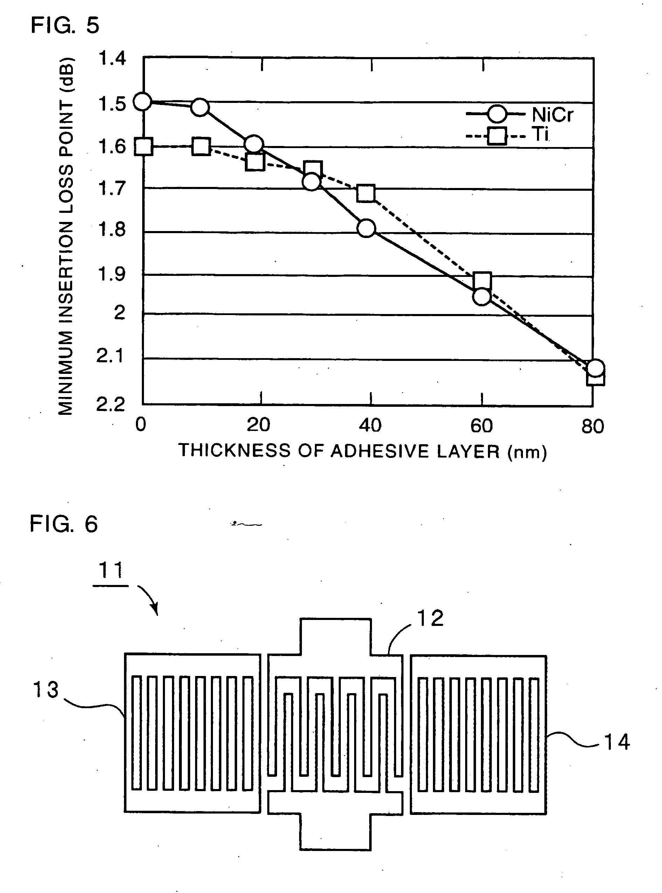

Fig. 4 is a graph showing changes in breakdown power with varying thicknesses of the adhesive layer 3b. Fig. 5 is a graph showing changes in minimum insertion loss point with varying thicknesses of the adhesive layer.

Fig. 4 clearly shows that the surface acoustic wave devices including the adhesive layer 3b formed of NiCr or Ti had higher power resistance than the device including no adhesive layer 3b (the thickness of the adhesive layer = 0 nm). Fig. 5 clearly shows that the minimum insertion loss points increased as the thicknesses of the adhesive layers were increased.

The minimum insertion loss point is preferably 2.0 dB or less, and a power resistance of 1.5 W or more is required for use on the transmitter side of communication equipment. If, therefore, a NiCr adhesive layer is formed in order to provide an excellent surface acoustic wave device 1, the adhesive layer preferably has a thickness of 5 to 50 nm, namely a normalized thickness h/λW = 0.0025 to 0.025, as shown in the results in Figs. 4 and 5.

If, on the other hand, the adhesive layer 3b is formed of Ti, the power resistance increases with increasing thickness of the adhesive layer 3b, as shown in Fig. 4. The minimum insertion loss point, however, tends to deteriorate with increasing thickness of the Ti adhesive layer.

According to Figs. 4 and 5, therefore, the Ti adhesive layer preferably has a thickness of 18 to 60 nm, namely a normalized thickness h/λW = 0.009 to 0.03, to achieve a power resistance of 1.5 W or more and a minimum insertion loss point of 2.0 dB or less.

Example 2 demonstrated that the power resistance can be increased effectively by forming an adhesive layer with NiCr below a main electrode layer mainly containing Cu. In particular, a power resistance of 1.5 W or more can be achieved by adjusting the thickness of the adhesive layer within the above preferred range.

In addition, Example 1 above demonstrated that the protective layer 3c not only can improve the oxidation resistance but also can increase the power resistance more effectively with no deterioration in minimum insertion loss.

The adhesive layer 3b was formed of NiCr in Example 2, though a material mainly containing NiCr may also be used.

Though the surface acoustic wave devices according to the present invention have the above multilayer electrode structures, the present invention may be applied to any surface acoustic wave device. The planar shape of interdigital electrodes may therefore be suitably changed according to the type of surface acoustic wave device to be produced. Figs. 6 to 9 are schematic plan views of examples of the electrode structures of surface acoustic wave devices according to the present invention.

Fig. 6 shows the electrode structure of a one-port surface acoustic wave resonator 11. In Fig. 6, reflectors 13 and 14 are disposed on both sides of interdigital electrodes 12.

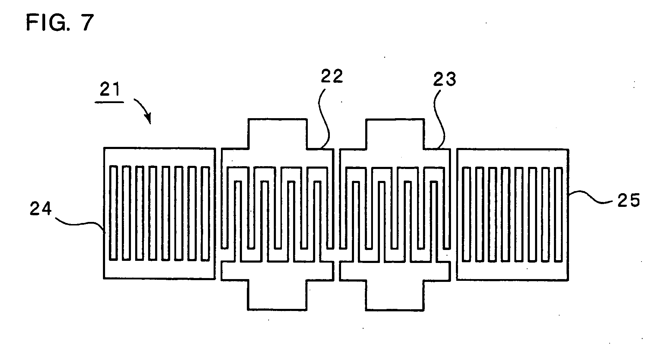

Fig. 7 shows the electrode structure of a two-port surface acoustic wave resonator 21. In Fig. 7, interdigital electrodes 22 and 23 are arranged in parallel in a direction in which a surface wave propagates, and reflectors 24 and 25 are disposed on both sides of the interdigital electrodes 22 and 23.

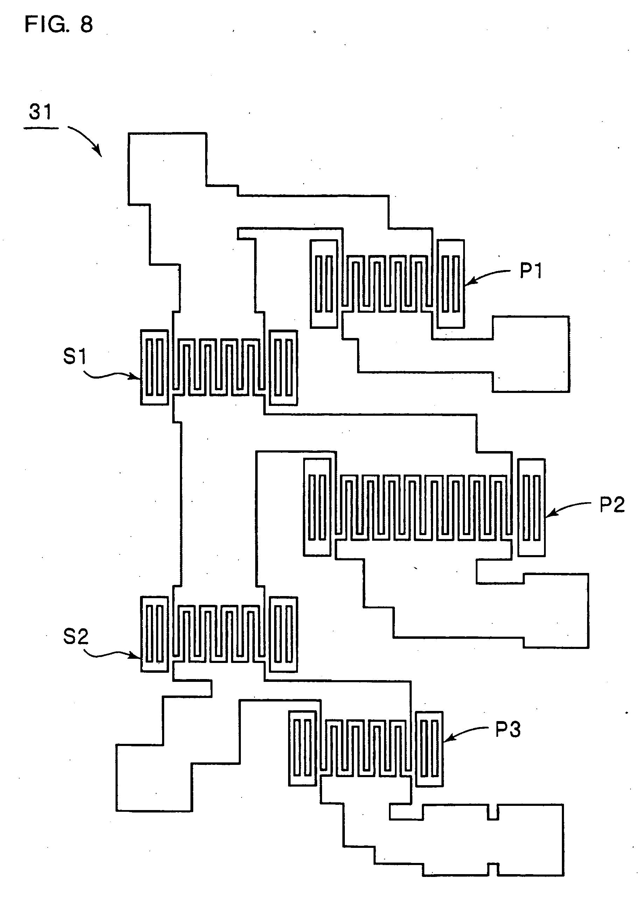

Fig. 8 is a schematic plan view showing the electrode structure of a ladder surface acoustic wave filter 31. The ladder surface acoustic wave resonator 31 includes series resonators S1 and S2 and parallel resonators P1 to P3 that are connected through connection electrodes to form a ladder circuit configuration. The series resonators S1 and S2 and the parallel resonators P1 to P3 are composed of one-port surface acoustic wave resonators.

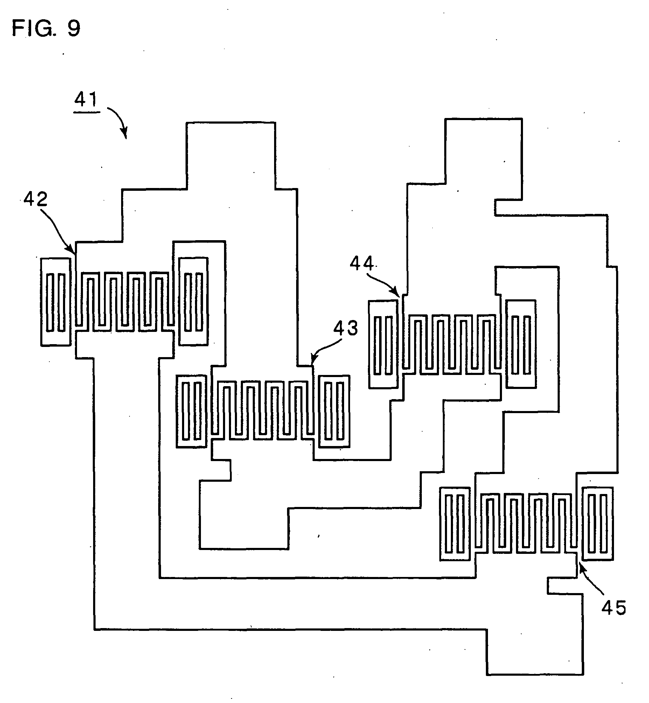

Fig. 9 shows the electrode structure of a lattice surface acoustic wave filter as another example of a surface acoustic wave device according to the present invention. A lattice surface acoustic wave filter 41 includes one-port surface acoustic wave resonators 42 to 45 that are electrically connected though connection electrodes to form a lattice-like connection.

The surface acoustic wave resonators 11 and 21 in Figs. 6 and 7, respectively, and the surface acoustic wave filters 31 and 41 in Figs. 8 and 9, respectively, include interdigital electrodes according to the present Invention to achieve extremely higher power resistance with no significant effect on frequency characteristics. In addition, a protective layer may be optionally formed to increase the oxidation resistance and the power resistance more effectively.

### Industrial Applicability

The surface acoustic wave device according to the first invention includes a piezoelectric substrate and interdigital electrodes formed thereon. The interdigital electrodes each include: a main electrode layer formed of Cu or an alloy mainly containing Cu, and an adhesive layer disposed between the main electrode layer and the substrate and mainly containing NiCr. The adhesive layer can increase the oxidation resistance effectively with no significant effect on, for example, frequency characteristics. If, particularly, the adhesive layer has a thickness of 5 to 50 nm, or a normalized thickness of 0.0025 to 0.025, the power resistance can be increased effectively to, for example, 1.5 W or more with no significant deterioration in frequency characteristics.

If the surface acoustic wave devices according to the invention further include a protective layer disposed on the main electrode layer and mainly containing a metal having higher oxidation resistance than Cu, the protective layer can increase the oxidation resistance and the power resistance more effectively. This allows the production of a surface acoustic wave device having excellent oxidation resistance and still higher power resistance.

If a Si02 film is formed over the interdigital electrodes, the Si02 film can improve the frequency characteristics of the surface acoustic wave devices with respect to temperature with improved power resistance according to the present invention.

## Claims

1. A surface acoustic wave device (1) comprising a piezoelectric substrate (2) and interdigital electrodes (3) formed thereon each including a main electrode layer (3a) formed of Cu or of an alloy mainly containing Cu and an adhesive layer (3b) disposed between the main electrode layer (3a) and the substrate (2) and mainly containing NiCr, wherein the thickness of the adhesive layer (3b) which is normalized with respect to the wavelength of a surface acoustic wave is 0.0025 to 0.025.

2. The surface acoustic wave device (1) according to Claim 1, wherein the adhesive layer (3b) has a thickness of 5 to 50 nm.

3. The surface acoustic wave device according to Claim 1 or 2, further comprising a protective layer (3c) disposed on the main electrode layer (3a) and mainly containing a metal having higher oxidation resistance than Cu.

4. The surface acoustic wave device according to Claim 3, wherein the protective layer (3c) comprises an Al-Cu alloy.

5. The surface acoustic wave device according to Claim 3 or 4, wherein an electrode layer comprising Ti or NiCr is disposed between the protective layer(3c) and the main electrode layer (3a).

6. The surface acoustic wave device according to any of Claims 1 to 5, further comprising a SiO₂ film (4) formed over the interdigital electrodes (3).

## Patentansprüche

1. Akustisches Oberflächenwellengerät (1), umfassend ein piezoelektrisches Substrat (2) und darauf gebildete interdigitale Elektroden (3), welche jeweils eine Hauptelektrodenschicht (3a), welche aus Cu oder aus einer Legierung gebildet ist, welche hauptsächlich Cu enthält, und eine Klebeschicht (3b) umfaßt, welche zwischen der Hauptelektrodenschicht (3a) und dem Substrat (2) angeordnet ist, und hauptsächlich NiCr umfaßt, wobei die Dicke der Klebeschicht (3b), welche hinsichtlich der Wellenlänge einer akustischen Oberflächenwelle normalisiert ist, 0,0025 bis 0,025 beträgt.

2. Akustisches Oberflächenwellengerät (1) nach Anspruch 1, wobei die Klebeschicht (3b) eine Dicke von 5 bis 50 nm aufweist.

3. Akustisches Oberflächenwellengerät nach Anspruch 1 oder 2, ferner umfassend eine Schutzschicht (3c), welche auf der Hauptelektrodenschicht (3a) angeordnet ist und hauptsächlich ein Metall mit höherer Oxidationsbeständigkeit als Cu enthält.

4. Akustisches Oberflächenwellengerät nach Anspruch 3, wobei die Schutzschicht (3c) eine Al-Cu-Legierung umfaßt.

5. Akustisches Oberflächenwellengerät nach Anspruch 3 oder 4, wobei eine Elektrodenschicht, welche Ti oder NiCr umfaßt, zwischen der Schutzschicht (3c) und der Hauptelektrodenschicht (3a) angeordnet ist.

6. Akustisches Oberflächenwellengerät nach einem der Ansprüche 1 bis 5, ferner umfassend einen SiO₂-Film (4), welcher über den interdigitalen Elektroden (3) gebildet ist.

## Revendications

1. Dispositif à ondes acoustiques de surface (1) comprenant un substrat piézoélectrique (2) et des électrodes interdigitées (3) formées sur ce dernier, chacune comprenant une couche d'électrode principale (3a) formée de Cu ou un alliage contenant principalement Cu et une couche adhésive (3b) disposée entre la couche d'électrode principale (3a) et le substrat (2) et contenant principalement NiCr, dans lequel l'épaisseur de la couche adhésive (3b) qui est normalisée par rapport à la longueur d'onde d'une onde acoustique de surface est de 0,0025 à 0,025.

2. Dispositif à ondes acoustiques de surface (1) selon la revendication 1, dans lequel la couche adhésive (3b) a une épaisseur de l'ordre de 5 à 50 nm.

3. Dispositif à ondes acoustiques de surface selon la revendication 1 ou 2, comprenant en outre une couche de protection (3c) disposée sur la couche d'électrode principale (3a) et contenant principalement un métal ayant une résistance à l'oxydation supérieure à Cu.

4. Dispositif à ondes acoustiques de surface selon la revendication 3, dans lequel la couche de protection (3c) comprend un alliage de Al-Cu.

5. Dispositif à ondes acoustiques de surface selon la revendication 3 ou 4, dans lequel une couche d'électrode comprenant Ti ou NiCr est disposée entre la couche de protection (3c) et la couche d'électrode principale (3a).

6. Dispositif à ondes acoustiques de surface selon l'une quelconque des revendications 1 à 5, comprenant en outre un film de SiO₂ (4) formé sur les électrodes inter-digitées (3).
